Europäisches Patentamt

European Patent Office

Office européen des brevets

(11) Publication number: 0 298 646
A2

# EUROPEAN PATENT APPLICATION

(21) Application number: 88305905.7

(22) Date of filing: 29.06.88

(51) Int. Cl.4: C04B 35/00 , H01L 39/24 , C01G 3/00

(30) Priority: 10.07.87 DK 3579/87

(43) Date of publication of application:
11.01.89 Bulletin 89/02

(84) Designated Contracting States:
AT BE CH DE FR GB GR IT LI LU NL SE

(71) Applicant: Haldor Topsoe A/S
Nymollevej 55
DK-2800 Lyngby(DK)

(72) Inventor: Johansen, Keld
Haspeholmsalle 4
DK-3600 Friderikssund(DK)
Inventor: Pederson, Erik
Bybjergvej 21
DK-2970 Horsholm(DK)

(74) Representative: Hartley, David et al
c/o Withers & Rogers 4 Dyer's Buildings
Holborn
London, EC1N 2JT(GB)

(54) A process for the preparation of a crystalline compound having superconducting properties.

(57) Crystalline compounds having superconducting properties and the general formula $(Me^1)_p (Me^2)_q Cu_3 O_x$, wherein $Me^1$ is selected from Y, Sc and the lanthanides, $Me^2$ is Ba and/or Sr, p is a number 0.8-2.5, q is a number 0.8-3, and x is a number 6-8.5, are prepared by forming an homogenous solution of salts, especially nitrates or acetates, of $Me^1$, $Me^2$ and Cu in a solvent, preferably water, calcining the salts by rapid heating of the solution in the presence of water and simultanously or subsequently subjecting the obtained intimate, dry oxides mixture to a thermal reaction to form the desired compound at 800-1400°C. By starting from a homogenous solution of salts one achieves that the oxides are formed in an extraordinarily intimate mixture, which facilitates the reaction between them by the solids phase reaction known per se to form a Y-Ba-Cu-O product having good superconducting properties.

Xerox Copy Centre

EP 0 298 646 A2

# A PROCESS FOR THE PREPARATION OF A CRYSTALLINE COMPOUND HAVING SUPERCONDUCTING PROPERTIES

## Field and Background of the Invention

The present invention relates to a special process for the preparation of a crystalline compound having superconducting properties and the general formula $(Me^1)_p(Me^2)_q Cu_3 O_x$, where $Me^1$ is one or more of the metals yttrium, scandium and the rare earth metals, $Me^2$ is barium and/or strontium, p is a number 0.8-2.5, q is a number 0.8-3 and x is a number 5-8.5 in which process oxides of $Me^1$, $Me^2$ and Cu are finally reacted with each other in the solid state at an elevated temperature.

It is known that metal-oxide ceramic compounds of this kind, which are frequently called Y-Ba-Cu-O and in which the metals are present in the oxidic form, possess electrically superconducting properties at a substantially higher temperature than that known for classic superconductors (up to about 23 K), viz. at a temperature above the boiling point of liquid nitrogen at atmospheric pressure.

Although the metals in compounds of this kind typically are yttrium, barium and copper, yttrium may be entirely or partly replaced by scandium and/or one or more lanthanides, and barium entirely or partly by strontium. In the materials of this kind so far known, copper is compulsory; it is known that the superconducting properties are improved concurrently with the degree to which copper is present at a higher oxidation state than 2, preferably predominantly or entirely in oxidation state 3. Known materials of the kind in question have, for example, the composition $YBa_2 Cu_3 O_z$, where z is a number 6 to 8, or $La_{1.85}Ba_{0.15}CuO_4$.

Surveys of superconducting substances of the kind in question are, i.a., an article by Ron Dagani in Chemical & Engineering News, May 11, 1987, pp. 7-16, and by Ib Johannsen and Thomas Bjørnholm in Dansk Kemi 5, May, 1987, pp. 172-175. There is a bibliography in the latter.

It is known that such compounds can be prepared by a solid phase reaction between suitable compounds, e.g. oxides, carbonates or oxalates, in powder form under an oxygen-containing atmosphere; that the reaction must be conducted under a controlled temperature profile; and that the composition of the surrounding atmosphere is important, notably the partial pressure of oxygen.

When using such processes for preparing superconducting compounds it is difficult to control the reaction conditions precizely enough and to bring about a sufficiently intimate contact between the reactants to obtain monophasic products having precizely the desired composition and having an expedient crystallite size, and it presents also difficulties to carry out the later compacting of the crystalline product prepared to form materials which as intermediate products or end products are suitable for the direct utilization of the superconducting properties.

## Disclosure of the Invention

It has now been surprizingly found that these difficulties may be overcome if according to the invention one forms an homogenous mixture of salts of the metals $Me^1$, $Me^2$ and Cu in a solvent or solvent mixture, thereafter decomposes the solution by a rapid heating of the solution in the presence of oxygen and simultaneously or subsequently subjects the obtained intimate dry oxides mixture to said reaction by a heat treatment at 800-1400° C. This final heat treatment, which expediently takes place at 900-950° C, ensures the desired crystallite structure.

As salts one can in principle employ any salts the anion of which escapes in the gaseous state or forms gaseous substances (e.g. aqueous vapour). However, also another consideration is to be applied: they have to be fairly soluble in the chosen solvent since it is important that the amounts of salts chosen for stoichiometric reasons are dissolved completely in the solvent so that the solution is homogenous with certainty. It is very convenient to employ water as the solvent, and since several of the salts it might be appropriate to use are rather sparingly soluble in water, and as for obvious reasons it is desired to keep the amount of solvent as low as possible, one may according to the invention expediently in many cases use water having a temperature near the boiling point of the solution.

According to the invention it is particularly expedient to employ nitrates as salts of the three metals since nitrates as a rule will be readily available and by the thermal decomposition (the calcination) release nitrogen oxides which if desired can be collected and used in a nitric acid plant. If $Me^2$ is to be barium it is notably when using nitrates important that the water employed as solvent is hot, since the solubility of barium nitrate in cold water is only 8.7 g/100 ml, whereas in hot water it is 34.2 g/100 ml. Strontium nitrate and the hexahydrates of yttrium nitrate and copper nitrate in contradistinction are readily soluble in cold water.

According to the invention it is also possible to employ salts with one or more carboxylic acids as salts of the metals $Me^1$, $Me^2$ and Cu, according to the invention expediently the acetates. Both barium acetate and strontium acetate are easily soluble in water; the solubility of copper acetate in cold water is 7.2 g/100 ml, in hot water 20 g/100 ml. The solubility of yttrium acetate in hot water is 9 g/100 ml so it will be understood that when acetates are chosen as reactants it is important to use hot water as solvent.

In any case the solvent may contain the acid corresponding to the anions of the salts.

By mixing salts of the desired metals in solution in this manner, preferably aqueous solution, there is obtained an intimate mixture of reactants, which results in a corresponding intimate mixture of the oxides in the subsequent thermal decomposition. Hereby the difficulties in known solid phase reactions are overcome; it has been found very convenient to proceed as explained in order to prepare monophasic crystallites having superconducting properties and not accompanied by undesired by-products.

The thermal decomposition of the metal salts expediently can take place at 600-700° C, a temperature at which nitrates are typically calcined to form oxides.

The final heat treatment of the dry oxides expediently takes place at about 920° C and is carried out in an oven, according to the invention suitably under air or an oxygen-enriched atmosphere, notably pure oxygen, because thereby one has particularly good possibilities of ensuring that the final product is obtained with a composition in which Cu to a high degree is present in an oxidation state of above 2; this high oxidation step of Cu, notably of about 3, is known to be advantageous for the superconducting properties of the product.

With respect to the process technology it may according to the invention, however, be the simplest if according to the invention the thermal decomposition (calcination) and the final heat treatment are carried out as one step, in one sequence at a temperature in the range of 800-1400° C. In practice this may very suitably be done by pouring the solution of the metal salts dropwise onto a metal surface or ceramic surface having a temperature in the range of, for instance, 900-1500° C.

The cooling is normally carried out in the same oven as that in which the final heat treatment is carried out and by discontinuing the supply of heat so that the cooling takes place spontaneously and hence slowly. Even the cooling preferably takes place in an oxygen-enriched atmosphere, notably under pure oxygen.

The process according to the invention is to be exemplified in the following.

Example

52.3 g of $Na(NO_3)_2$ were dissolved in 414 g of hot $H_2O$.

11.3 g of $Y_2O_3$ were dissolved in 31.0 g of 65% $HNO_3$.

These two solutions of metal nitrates were mixed with 107.6 g of $Cu(NO_3)_2$ containing 17.8%w of Cu.

A thorough mixing was carried out at a temperature near the boiling point of the solution, after which the solution was poured dropwise onto a flat crucible in an oven at a temperature of about 650° C. Hereby so rapid a drying and decomposition (calcination) took place that a homogenous mixture of the oxides of yttrium, barium and copper resulted.

The homogenous mixture was thereafter subjected to a heat treatment in an oven under an oxygen-containing atmosphere at 950° C and then cooled slowly in the same oven, likewise under an oxygen-containing atmosphere.

The material thus produced was a monophasic superconductor having very well-defined critical properties.

**Claims**

1. A process for the preparation of a crystalline compound having superconducting properties and the general formula $(Me^1)_p(Me^2)_qCu_3O_x$, wherein $M^1$ is one or more of the metals yttrium, scandium and the lanthanides, $Me^2$ is barium and/or strontium, p a number 0.8 to 2.5, q a number 0.8 to 3 and x a number 6 to 8.5, in which process oxides of $Me^1$, $Me^2$ and Cu are finally reacted with each other in the solid state at an elevated temperature, characterized in forming an homogenous solution of salts of $Me^1$, $Me^2$ and Cu in a solvent or solvent mixture, thereafter decomposing the salts thermally by a rapid heating of the solution in the presence of oxygen and simultaneously or subsequently subjecting the obtained intimate, dry oxides mixture to said reaction by a heat treatment at 800-1400° C.

2. A process according to claim 1, characterized in using water as the solvent, preferably water at a temperature close to the boiling point of the solution.

3. A process according to claim 1 or claim 2, characterized in using nitrates as salts of the metals $Me^1$, $Me^2$ and Cu.

4. A process according to claim 1 or claim 2, characterized in using salts of one or more carboxylic acids as salts of the metals $Me^1$, $Me^2$ and Cu.

5. A process according to claim 4, characterized in using acetates as carboxylic acid salts.

6. A process according to claim 1 or 2, characterized in that the thermal decomposition of the metal salts in solution takes place at a temperature of 500-1000°C.

7. A process according to anyone of claims 1 to 5, characterized in that the thermal decomposition and the final heat treatment take place as one step at a temperature in the range of 800-1400°C.

8. A process according to claim 6 or claim 7, characterized in that the final heat treatment of the dry oxides takes place under an oxygen-enriched atmosphere, preferably in pure oxygen.